# EUROPÄISCHE PATENTANMELDUNG

(11) **EP 1 892 761 A2**
(43) Veröffentlichungstag der Anmeldung: **27.02.2008**
(21) Anmeldenummer: 07016707.7
(22) Anmeldetag: 25.08.2007
(51) Int. Cl.: H01L 25/07

(54) **Niederinduktives Leistungshalbleitermodul für stromeingeprägte Leistungsschaltungen**

(30) Priorität: 25.08.2006 DE 102006039975
(71) Anmelder: SEMIKRON Elektronik GmbH & Co. KG, 90431 Nürnberg (DE)
(72) Erfinder: Schreiber, Dejan, 90408 Nürnberg (DE)

(57) **Zusammenfassung**

Leistungshalbleitermodul in Teilmodule aufgeteilt für stromeingeprägte Leistungsschaltungen in H-Brückentopologie. Ein erstes Teilmodul weist zwei erste Stromventile mit einem gemeinsamen Anschluss positiver Polarität sowie zwei elektrisch getrennten Wechselspannungsanschlüssen auf. Ein zweites Teilmodul weist zwei zweite Stromventile mit einem gemeinsamen Anschluss negativer Polarität sowie zwei elektrisch getrennten Wechselspannungsanschlüssen auf. Hierbei sind die ersten Stromventile, wie auch die zweiten Stromventile und auch die Wechselspannungsanschlüsse jeweils eng benachbart zueinander angeordnet. Somit ist die jeweilige stromumflossene Fläche bei der Kommutierung zwischen den jeweiligen ersten oder den jeweiligen zweiten Stromventilen klein. Weiterhin weist jedes Stromventil eine schaltbare Durchlassrichtung und eine Sperrrichtung auf.

## Beschreibung

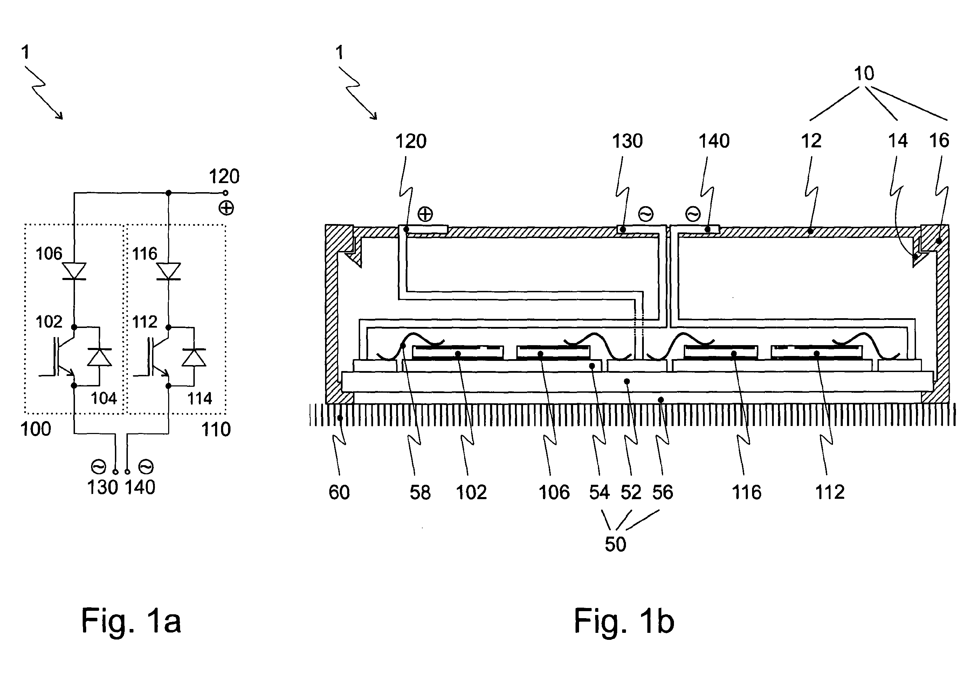

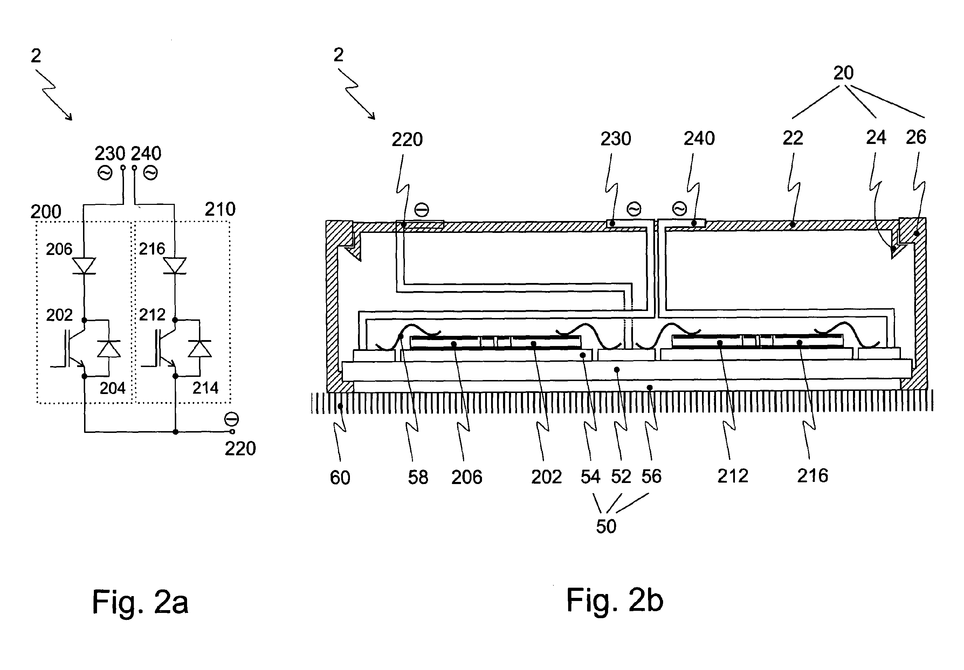

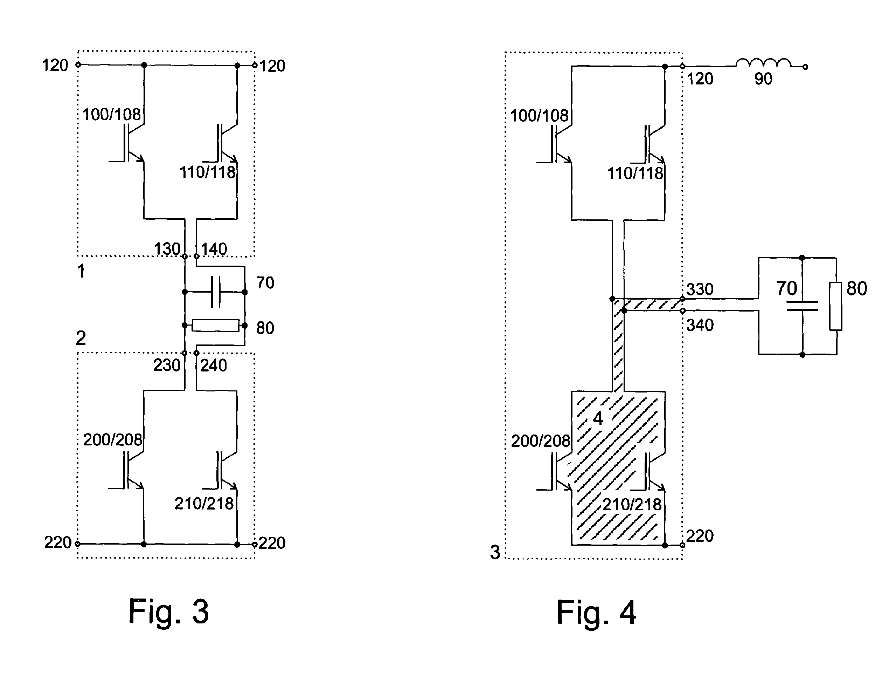

[1] Es wird ein Leistungshalbleitermodul für stromeingeprägte Leistungsschaltungen vorgestellt, wobei die parasitären Induktivitäten im Inneren des Leistungshalbleitermoduls gering sind. Hierbei sollen Leistungshalbleitermodule mit einer Schaltungsanordnung in sog. H-Brückentopologie sowie Teilmodule hiervon betrachtet werden. Der grundlegende Stand der Technik von Leistungshalbleitermodulen wird beispielhaft gebildet aus der DE 39 37 045 A1 und der DE 100 37 533 C1.
[2] In der DE 39 37 045 wird für eine Halbbrücke eine Schaltungsanordnung zur Reduzierung der parasitären Induktivitäten in den Gleichstromzuleitungen beschrieben. Hierbei werden die beiden Gleichstromzuleitungen eng benachbart und zumindest teilweise parallel zueinander angeordnet. Dies bewirkt im Kommutierungsfall bei spannungseingeprägten Leistungsschaltungen eine Verkleinerung der stromumflossenen Fläche im Leistungshalbleitermodul.
[3] Die DE 100 37 533 C1 offenbart eine modernere, sehr aufwändige, aber auch sehr wirksame Schaltungsanordnung zur Reduktion der parasitären Induktivitäten bei spannungseingeprägten Leistungsschaltungen. Hierbei werden alle stromumflossenen Flächen innerhalb eines Leistungshalbleitermoduls soweit als möglich minimiert.
[4] Allen Leistungshalbleitermodulen gemäß des beschriebenen Standes der Technik weisen eine Verringerung der parasitären Induktivitäten für spannungseingeprägte Leistungsschaltungen. Die Anforderungen zur Verringerung der parasitären Induktivitäten im Inneren eines Leistungshalbleitermoduls bei stromeingeprägten Leistungsschaltungen unterscheiden sich demgegenüber.
[5] Der Erfindung liegt die Aufgabe zugrunde ein Leistungshalbleitermodul für stromeingeprägte Leistungsschaltungen vorzustellen, das geringe parasitäre Induktivitäten aufweist, und einer einfachen Herstellung zugänglich ist.
[6] Die Aufgabe wird erfindungsgemäß gelöst, durch die Maßnahmen der Merkmale des Anspruchs 1. Bevorzugte Ausführungsformen sind in den Unteransprüchen beschrieben.
[7] Das erfindungsgemäße Leistungshalbleitermodul für stromeingeprägte Leistungsschaltungen in H-Brückentopologie weist ein erstes und ein zweites Teilmodul auf, wobei diese alternativ in je einem eigenen Gehäuse mit externen Anschlusselementen oder auch in einem gemeinsamen Gehäuse angeordnet sein können. Das erste Teilmodul weist zwei erste Stromventile mit einem gemeinsamen Anschluss positiver Polarität auf. Jedes Stromventil weist hierbei eine schaltbare Durchlassrichtung und eine Sperrrichtung auf. Weiterhin weist das Teilmodul zwei elektrisch voneinander getrennte Wechselspannungsanschlüssen auf.
[8] Das zweite komplementär ausgebildete Teilmodul weist zwei zweite Stromventile mit einem gemeinsamen Anschluss negativer Polarität sowie ebenfalls zwei elektrisch voneinander getrennte Wechselspannungsanschlüsse auf.
[9] Die jeweiligen ersten und zweiten Stromventile sind eng benachbart zueinander angeordnet, wodurch die jeweilige stromumflossene Fläche bei der Kommutierung zwischen den jeweiligen ersten oder den jeweiligen zweiten Stromventilen klein ist. Durch die genannte Anordnung weist das Leistungshalbleitermodul geringe parasitäre Induktivitäten für stromeingeprägte Leistungsschaltungen auf.
[10] Der erfinderische Gedanke wird anhand der Ausführungsbeispiele in den Fig. 1 bis 4 näher erläutert.
[11] Fig. 1 zeigt ein erstes Teilmodul eines erfindungsgemäßen Leistungshalbleitermoduls.
[12] Fig. 2 zeigt ein zweites Teilmodul eines erfindungsgemäßen Leistungshalbleitermoduls.
[13] Fig. 3 zeigt das Schaltbild einer Anordnung eines ersten und eines zweiten Teilmoduls mit jeweils eigenem Gehäuse mit einer Last.
[14] Fig. 4 zeigt die Anordnung eines ersten und eines zweiten Teilmoduls mit einem gemeinsamen Gehäuse mit einer Last.
[15] Fig. 1 zeigt ein erstes Teilmodul (1) eines erfindungsgemäßen Leistungshalbleitermoduls als Schaltbild, Fig.1a und im Querschnitt, Fig. 1 b. In Fig. 1 a sind die beiden ersten Stromventile (100, 110) dargestellt wobei das jeweilige Stromventile aus einer seriellen Anordnung einer Diode (106, 116) und eines Transistors (102, 112) besteht. Die Anoden der jeweiligen Diode (106, 116) sind miteinander und mit dem Gleichspannungsanschluss (120) positiver Polarität des Teilmoduls (1) verbunden. Die jeweiligen Kathoden der Dioden (106, 116) sind mit dem Kollektor des zugeordneten Transistors (102, 112), der hier als IGBT (insulated gate bipolar transistor) ausgebildet ist, verbunden. Der Emitter des jeweiligen Transistors (102, 112) ist mit einem der beiden zugeordneten Wechselspannungsanschlüsse (130, 140) verbunden. Es kann ebenso vorteilhaft sein die Dioden (106, 116) derart seriell mit dem jeweils zugeordneten Transistoren (102, 112) anzuordnen, dass der Emitter des Transistors mit der Anode der Diode verbunden ist.
[16] Es kann weiterhin bevorzugt sein antiparallel zum jeweiligen Transistor (102, 112) noch eine Diode (104, 114) zu schalten um den Transistor vor Spannungsspitzen in Sperrrichtung zu schützen.
[17] Fig. 1 b zeigt einen Schnitt durch ein auf einem Kühlkörper (60) angeordnetes erstes Teilmodul (1) des erfindungsgemäßen Leistungshalbleitermoduls. Dieses Teilmodul (1) weist ein Substrat (50), ein dieses Substrat (50) umrahmendes Gehäuseteil (16) und einen hiermit mittels einer Schnapp- Rast- Verbindung (14) verbundenen Gehäusedeckel (12) auf. Das Substrat (50) weist einen Isolierstoffkörper (52) zur elektrischen Isolation zum Kühlkörper (60) auf. Auf der dem Kühlkörper (60) zugewandten Seite kann es vorteilhaft sein eine metallische Zwischenlage (56) zwischen dem Isolierstoffkörper (52) und dem Kühlkörper (60) anzuordnen.
[18] Auf der dem Kühlkörper (60) abgewandten Seite des Isolierstoffkörpers (52) sind eine Mehrzahl elektrisch voneinander isolierter Leiterbahnen (54) angeordnet. Ohne Beschränkung der Allgemeinheit ist es bevorzugt dieses Substrat als bekanntes DCB-(direct copper bonding) Substrat auszubilden.
[19] Auf zwei voneinander isolierten Leiterbahnen (54) sind jeweils die beiden ersten Stromventile angeordnet. Diese sind hier ausgebildet als je eine Diode (106, 116) und ein in Reihe geschalteter Transistor (102, 112). Die Anoden der Dioden (106, 116) sind mittels Drahtbondverbindungen (58) mit einer weiteren Leiterbahn (54) verbunden, die auf positivem Gleichspannungspotential liegt und mit einem externen Gleichspannungsanschluss (120) verbunden ist.
[20] Die elektrische Verbindung zwischen der Kathode der jeweiligen Diode (106, 116) und dem Kollektor des zugeordneten Transistors (102, 112) erfolgt mittels der gemeinsamen Leiterbahn (54). Die Verbindung zwischen dem jeweiligen Emitter und einer zugeordneten Leiterbahn (54) mit Wechselspannungspotential erfolgt wiederum mittels einer Drahtbondverbindung (58). Die Wechselspannungsanschlusselemente (130, 140), die die zugeordnete Leiterbahn kontaktieren, sind derart ausgebildet, dass die stromumflossene Fläche im Kommutierungsfall klein ist und somit auch die parasitären Induktivitäten klein sind.
[21] Fig. 2 zeigt ein zweites Teilmodul (2) eines erfindungsgemäßen Leistungshalbleitermoduls als Schaltbild, Fig.2a und im Querschnitt, Fig. 2b. Dieses zweite Teilmodul (2) ist komplementär zu demjenigen gemäß Fig. 1 ausgebildet. Im Schaltbild, Fig. 2a, sind die beiden zweiten Stromventile (200, 210) dargestellt, wiederum ausgebildet als eine serielle Anordnung einer Diode (206, 216) und eines Transistors (202, 212). Die Anoden der jeweiligen Dioden (206, 216) sind mit den zugeordneten elektrisch getrennten Wechselspannungsanschlüssen (230, 240) des Teilmoduls (2) verbunden. Die Kathode der jeweiligen Diode (206, 216) ist mit dem Kollektor des zugeordneten Transistors (202, 212) verbunden. Die Emitter der jeweiligen Transistoren (202, 212) sind miteinander und mit dem Gleichspannungsanschluss (220) negativer Polarität des Teilmoduls (2) verbunden. Es kann ebenso vorteilhaft sein die Dioden (206, 216) derart seriell mit dem jeweils zugeordneten Transistoren (202, 212) anzuordnen, dass der Emitter des Transistors mit der Anode der Diode verbunden ist.
[22] Fig. 2b zeigt einen Schnitt durch ein auf einem Kühlkörper (60) angeordnete zweites Teilmodul (2) des erfindungsgemäßen Leistungshalbleitermoduls. Dieses Teilmodul (2) weist das gleich Substrat (50) und Gehäuse (20) wie das erste Teilmodul, vgl. Fig. 1b auf, wodurch die Herstellung der jeweiligen Teilmodule effizient möglich ist.
[23] Auf zwei voneinander isolierten Leiterbahnen (54) sind die beiden ersten Stromventile (202, 212) angeordnet. Diese sind wiederum ausgebildet als je eine Diode (206, 216) und ein in Reihe geschalteter Transistor (202, 212). Die Emitter der Transistoren (202, 212) sind mittels Drahtbondverbindungen (58) mit eine weiteren Leiterbahn (54) verbunden, die auf negativem Gleichspannungspotential liegt und mit einem externen Gleichspannungsanschluss (220) verbunden ist.
[24] Die elektrische Verbindung zwischen den Kollektoren der Transistoren (202, 212) und den Kathoden der jeweiligen zugeordneten Diode (206, 216) erfolgt mittels der gemeinsamen Leiterbahn. Die Verbindung zwischen der Anode der jeweiligen Diode und einer zugeordneten Leiterbahn mit Wechselspannungspotential erfolgt wiederum mittels einer Drahtbondverbindung (58). Die Wechselspannungsanschlusselemente (230, 240) sind wiederum derart ausgebildet, dass die stromumflossene Fläche im Kommutierungsfall klein ist und somit auch die parasitären Induktivitäten klein sind.
[25] Fig. 3 zeigt das Schaltbild einer Anordnung eines ersten (1) und eines zweiten (2) Teilmoduls zu einem erfindungsgemäßen Leistungshalbleitermodul mit jeweils eigenem Gehäuse pro Teilmodul und mit einer Last (80). Hierbei sind die ersten Stromventile (100, 110) ausgebildet als in Sperrrichtung blockierende Bipolartransistoren (108, 118), sog. reverse blocking insulated gate bipolar transistor (RB-IGBT).
[26] Die beiden ersten RB-IGBT des ersten Teilmoduls (1) der Schaltung in H-Brückentopologie sind derart in einem Gehäuse angeordnet, dass die Kollektoren miteinander verbunden sind und in dieser Ausgestaltung mit einem doppelt vorhandenen externen Gleichspannungsanschluss (120) positiver Polarität verbunden sind. Die Emitter jedes RB-IGBTs (108, 118) sind mit je einem der Wechselspannungsanschlüsse (130, 140), wobei diese eng benachbart zueinander jedoch elektrisch voneinander getrennt angeordnet sind, verbunden.
[27] Die beiden zweiten Stromventile (200, 210), ebenfalls RB-IGBT (208, 218), des zweiten Teilmoduls (2) der Schaltung in H-Brückentopologie sind derart in einem Gehäuse angeordnet, dass die Kollektoren mit je einem zugeordneten Wechselspannungsanschluss (230, 240) verbunden sind und die Emitter der RB-IGBTs (208, 218) miteinander und in dieser Ausgestaltung mit einem doppelt vorhandenen externen Gleichspannungsanschluss (220) negativer Polarität verbunden sind. Auch hierbei sind die beiden Wechselspannungsanschlüsse (230, 240) eng benachbart zueinander jedoch elektrisch voneinander getrennt angeordnet.
[28] Die Anordnung weist weiterhin einen Filterkondensator (70) parallel geschaltet zur Last (80) und jeweils mit den Wechselspannungsanschlüssen (130, 230, 140 ,240) der beiden Teilmodule (1, 2) verbunden auf.
[29] Fig. 4 zeigt die Anordnung eines ersten und eines zweiten Teilmoduls in einem gemeinsamen Gehäuse (3) und mit einer Last (80). Die Stromventile (100, 110, 200, 210) sind wiederum ausgebildet als RB-IGBTs (108, 118, 208, 218). Allerdings sind in dieser Ausgestaltung die Emitter des jeweils ersten (108, 118) mit dem Kollektor des jeweils zweiten Stromventils (208, 218) einer Halbbrücke miteinander und mit dem zugeordneten Wechselspannungsanschluss (330, 340) des Leistungshalbleitermoduls verbunden. An die Wechselspannungsanschlüsse (330, 340) sind wiederum ein Filterkondensator (70) sowie parallel hierzu eine Last (80) geschaltet.
[30] Die Fläche (4) kennzeichnet hier die stromumflossene Fläche während eines beispielhaften Kommutierungsvorgangs. Durch die geeignete eng benachbarte Anordnung der Stromventile und der Wechselspannungsanschlüsse ist diese Fläche gering und somit sind auch die im Leistungshalbleitermodul auftretenden parasitären Induktivitäten gering.
[31] Weiterhin ist noch eine Spule (90) an einem Gleichspannungsanschluss (120, 220), hier demjenigen positiver Polarität, angeschlossen, die zum Betrieb der stromeingeprägten Leistungsschaltung notwendig ist.
[32] Ein derartiges Leistungshalbleitermodul kann beispielhaft ausgebildet werden, indem ein Teilmodul (1) gemäß Fig. 1 b und ein Teilmodul (2) gemäß Fig. 2b in Richtung der Papierebene hintereinander, und in diesem Fall in einem Gehäuse, angeordnet werden.

## Patentansprüche

1. Leistungshalbleitermodul für stromeingeprägte Leistungsschaltungen in H-Brückentopologie, wobei zu einem ersten Teilmodul (1) zwei erste Stromventile (100, 110) mit einem gemeinsamen Anschluss (120) positiver Polarität sowie zwei elektrisch getrennten Wechselspannungsanschlüssen (130, 140) angeordnet sind und wobei zu einem zweiten Teilmodul (2) zwei zweite Stromventile (200, 210) mit einem gemeinsamen Anschluss (220) negativer Polarität sowie zwei elektrisch getrennten Wechselspannungsanschlüssen (230, 240) angeordnet sind, wobei die ersten Stromventile (100, 110), wie auch die zweiten Stromventile (200, 210) und auch die Wechselspannungsanschlüsse (130, 140 und 230, 240) jeweils eng benachbart zueinander angeordnet sind und somit die jeweilige stromumflossene Fläche bei der Kommutierung zwischen den jeweiligen ersten oder den jeweiligen zweiten Stromventilen klein ist und wobei jedes Stromventil eine schaltbare Durchlassrichtung und eine Sperrrichtung aufweist.

2. Leistungshalbleitermodul nach Anspruch 1,
wobei jedes Teilmodul (1, 2) ein eigenes Gehäuse (20) mit Gleichspannungsanschluss (120, 220) einer Polarität und zwei eng benachbart angeordneten Wechselspannungsanschlüssen (130, 140 und 230, 240) aufweist.

3. Leistungshalbleitermodul nach Anspruch 1,
wobei die beiden Teilmodule (1, 2) in einem gemeinsamen Gehäuse (3) angeordnet sind mit Gleichspannungsanschlüssen (120, 220) positiver und negativer Polarität und zwei gemeinsamen eng benachbart angeordneten Wechselspannungsanschlüssen (330, 340).

4. Leistungshalbleitermodul nach Anspruch 1,
wobei das jeweilige Stromventil (100, 110, 200, 210) ein reverse blocking insulated gate bipolar transitor (RB-IGBT) (108, 118, 208, 218) ist.

5. Leistungshalbleitermodul nach Anspruch 1,
wobei das jeweilige Stromventil (100, 110, 200, 210) aus einer seriellen Anordnung einer Diode (106, 116, 206, 216) und eines Transistors (102, 112, 202, 212) besteht und hierbei die Kathode der Diode mit dem Kollektor des Transistors verbunden ist.

6. Leistungshalbleitermodul nach Anspruch 1,
wobei das jeweilige Stromventil (100, 110, 200, 210) aus einer seriellen Anordnung einer Diode (106, 116, 206, 216) und eines Transistors (102, 112, 202, 212) besteht und hierbei die Anode der Diode mit dem Emitter des Transistors verbunden ist.

7. Leistungshalbleitermodul nach Anspruch 5 oder 6,
wobei antiparallel zum Transistor (102, 112, 202, 212) eine weitere Diode (104, 114, 204, 214) geschaltet ist.
